# DEMANDE DE BREVET EUROPEEN

(11) **EP 4 350 890 A1**
(43) Date de publication de la demande: **10.04.2024**
(21) Numéro de dépôt: 23200717.9
(22) Date de dépôt: 29.09.2023
(51) Int. Cl.: H01Q 3/46, H01Q 3/24, H01Q 21/06, H10N 70/20, H01P 1/10

(54) **COMMUTATEUR A BASE D'UN MATERIAU A CHANGEMENT DE PHASE**

(30) Priorité: 07.10.2022 FR 2210292
(71) Demandeur: Commissariat à l'énergie atomique et aux énergies alternatives, 75015 Paris (FR)
(72) Inventeur: CLEMENTE, Antonio, 38054 GRENOBLE (FR); CHARBONNIER, Benoît, 38054 GRENOBLE (FR); DUPRE, Cécilia, 38054 GRENOBLE (FR); REIG, Bruno, 38054 GRENOBLE (FR)
(74) Mandataire: Cabinet Beaumont

(57) **Abrégé**

La présente description concerne un commutateur (C1) à base d'un matériau à changement de phase comprenant :
- une région (160) en ledit matériau à changement de phase reliant des première et deuxième électrodes de conduction (140P, 140C) du commutateur ; et
- un guide d'ondes (164) comportant une première extrémité en vis-à-vis d'une face de la région (160) en ledit matériau à changement de phase et une deuxième extrémité, opposée à la première extrémité, destinée à être illuminée par une source laser (LS).

## Description

### Domaine technique

La présente description concerne de façon générale les dispositifs électroniques et en particulier les dispositifs de type surfaces électromagnétiques reconfigurables. La présente demande concerne plus particulièrement le domaine des antennes radio à réseau transmetteur (« transmitarray antenna », en anglais) et des antennes radio à réseau réflecteur (« reflectarray antenna », en anglais).

### Technique antérieure

Parmi les différentes technologies d'antennes de communication radio existantes, on connaît notamment des antennes radio dites « à réseau transmetteur ». Ces antennes comprennent généralement plusieurs cellules élémentaires comportant chacune un premier élément d'antenne irradié par un champ électromagnétique émis par une ou plusieurs sources, un deuxième élément d'antenne transmettant un signal modifié vers l'extérieur de l'antenne et un élément de couplage et déphasage entre les premier et deuxième éléments d'antenne.

On connaît en outre des antennes radio dites « à réseau réflecteur ». Ces antennes comprennent généralement plusieurs cellules élémentaires comportant chacune un élément d'antenne irradié par un champ électromagnétique émis par une ou plusieurs sources, un élément réflecteur, par exemple un plan de masse, réfléchissant un signal modifié vers l'extérieur de l'antenne et un élément de couplage entre l'élément d'antenne et l'élément réflecteur. À la différence des cellules élémentaires des antennes à réseau transmetteur, qui transmettent un signal radio dans une direction opposée à la ou aux sources irradiant leur premier élément d'antenne, les cellules élémentaires des antennes à réseau réflecteur réfléchissent un signal radio en direction de la ou des sources irradiant leur élément d'antenne.

Pour certaines applications, par exemple telles que la communication satellite (« satellite communication » ou « SatCom », en anglais), ou des applications de communication à très haut débit et à courte ou moyenne portée, par exemple à des fréquences supérieures à 80 GHz, il serait souhaitable de disposer d'antennes à réseau transmetteur et d'antennes à réseau réflecteur reconfigurables permettant de modifier, de façon dynamique, la phase de l'onde rayonnée.

### Résumé de l'invention

Il existe un besoin d'améliorer les antennes à réseau transmetteur et les antennes à réseau réflecteur existantes.

Un mode de réalisation pallie tout ou partie des inconvénients des antennes à réseau transmetteur et des antennes à réseau réflecteur connues. Un objet d'un mode de réalisation consiste plus particulièrement à permettre un contrôle électronique de phase dans une plage de fréquences comprises par exemple entre 80 et 350 GHz, correspondant à des longueurs d'ondes millimétriques, et de disposer de commutateurs dont la polarisation entraîne une consommation électrique réduite.

Pour cela, un mode de réalisation prévoit un commutateur à base d'un matériau à changement de phase comprenant :
- une région en ledit matériau à changement de phase reliant des première et deuxième électrodes de conduction du commutateur ; et
- un guide d'ondes comportant une première extrémité en vis-à-vis d'une face de la région en ledit matériau à changement de phase et une deuxième extrémité, opposée à la première extrémité, destinée à être illuminée par une source laser.

Selon un mode de réalisation, le guide d'ondes comprend une région centrale en nitrure de silicium entourée d'une région périphérique en dioxyde de silicium.

Selon un mode de réalisation, le matériau à changement de phase est un matériau chalcogénure.

Selon un mode de réalisation, les première et deuxième électrodes de conduction font partie d'un élément d'antenne d'une cellule de réseau transmetteur ou de réseau réflecteur.

Selon un mode de réalisation, les première et deuxième électrodes de conduction sont sur et en contact avec une face d'un substrat.

Selon un mode de réalisation, les première et deuxième électrodes de conduction sont sur et en contact avec une face d'une couche électriquement isolante revêtant un substrat.

Selon un mode de réalisation, au moins une extrémité, parmi les première et deuxième extrémités du guide d'ondes, permet de transmettre ou de recevoir un rayonnement selon une direction orthogonale à une direction de propagation du rayonnement à l'intérieur du guide d'ondes.

Selon un mode de réalisation, ladite extrémité du guide d'ondes présente une forme fuselée.

Selon un mode de réalisation, au moins une extrémité, parmi les première et deuxième extrémités du guide d'ondes, permet de transmettre ou de recevoir un rayonnement selon une direction parallèle à la direction de propagation du rayonnement à l'intérieur du guide d'ondes.

Un autre mode de réalisation prévoit une cellule de réseau transmetteur ou de réseau réflecteur comprenant au moins un commutateur tel que défini ci-dessus.

Un autre mode de réalisation prévoit un réseau transmetteur ou réseau réflecteur comprenant :
- une pluralité de cellules telles que défini ci-dessus ;
- une ou plusieurs sources laser ; et
- un circuit de commande de la ou des sources laser.

Selon un mode de réalisation, chaque source laser fait partie d'une même puce que chaque commutateur auquel elle est associée.

Selon un mode de réalisation, chaque source laser fait partie d'une puce différente de celle dont fait partie chaque commutateur auquel elle est associée, la source laser étant connectée au guide d'ondes dudit commutateur par une fibre optique.

Un autre mode de réalisation prévoit une antenne comprenant un réseau transmetteur ou un réseau réflecteur tel que défini ci-dessus et au moins une source configurée pour irradier une face du réseau.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue de côté, schématique et partielle, d'un exemple d'antenne à réseau transmetteur du type auquel s'appliquent, à titre d'exemple, des modes de réalisation décrits ;
la figure 2 est une vue en perspective, schématique et partielle, d'une cellule élémentaire du réseau transmetteur de l'antenne de la figure 1 selon un mode de réalisation ;
la figure 3 est une vue de dessus, schématique et partielle, d'un premier élément d'antenne de la cellule élémentaire de la figure 2 ;
la figure 4 est une vue de dessus, schématique et partielle, d'une partie de la cellule élémentaire de la figure 2 ;
la figure 5 est une vue de dessus, schématique et partielle, d'un deuxième élément d'antenne de la cellule élémentaire de la figure 2 ;
la figure 6 est une vue en coupe, schématique et partielle, d'un commutateur à base d'un matériau à changement de phase avec commande optique intégrée selon un mode de réalisation ;
la figure 7 est une vue en coupe, schématique et partielle, d'un autre commutateur à base d'un matériau à changement de phase avec commande optique intégrée selon un mode de réalisation ;
la figure 8 est une vue en perspective d'une surface de sortie d'un guide d'ondes selon un mode de réalisation ; et
la figure 9 est une vue en perspective d'une surface de sortie d'un guide d'ondes selon un autre mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, on va décrire ci-après des modes de réalisation d'une cellule pour antenne à réseau transmetteur et des modes de réalisation d'une cellule pour antenne à réseau réflecteur. La structure et le fonctionnement de la ou des sources primaires de l'antenne, destinées à irradier le réseau transmetteur ou le réseau réflecteur, ne seront toutefois pas détaillées, les modes de réalisation décrits étant compatibles avec toutes ou la plupart des sources primaires d'irradiation pour antenne à réseau transmetteur ou à réseau réflecteur connues. À titre d'exemple, chaque source primaire est adaptée à produire un faisceau de forme générale conique irradiant tout ou partie du réseau transmetteur ou du réseau réflecteur en condition de champ proche ou de champ lointain. Chaque source primaire comprend par exemple une antenne cornet. À titre d'exemple, l'axe central de chaque source primaire est sensiblement orthogonal au plan moyen du réseau ou en configuration d'offset (déplacé par rapport à l'axe central et tourné de manière à illuminer la surface du réseau réflecteur. Cette illumination est typique dans le cas d'un réseau réflecteur pour réduire le phénomène de blocage.

Par ailleurs, les procédés de fabrication des réseaux transmetteur et des réseaux réflecteurs décrits ne seront pas détaillés, la réalisation des structures décrites étant à la portée de la personne du métier à partir des indications de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence sauf précision contraire à l'orientation des figures.

Sauf précision contraire, les expressions « environ », « approximativement », « sensiblement », et « de l'ordre de » signifient à 10 % près, de préférence à 5 % près.

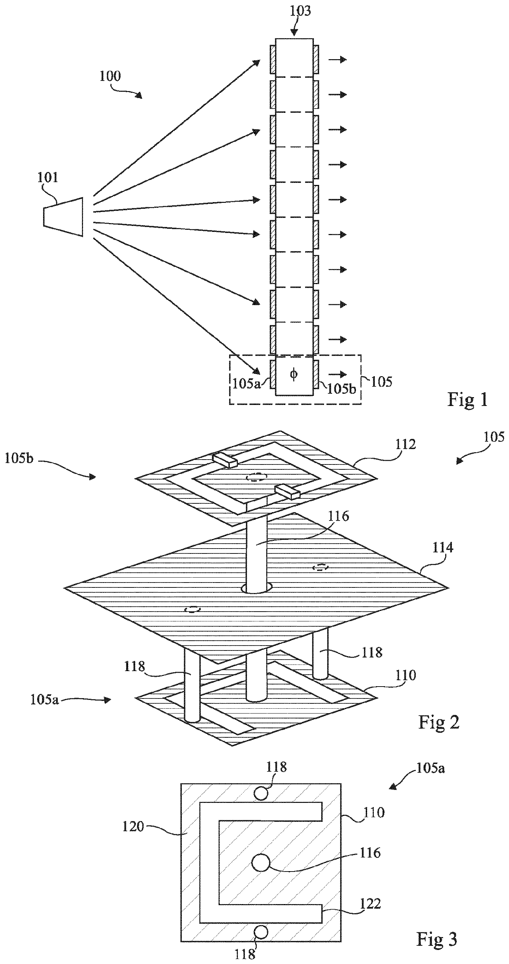

La figure 1 est une vue de côté, schématique et partielle, d'un exemple d'antenne 100 à réseau transmetteur du type auquel s'appliquent, à titre d'exemple, des modes de réalisation décrits.

L'antenne 100 comprend typiquement une ou plusieurs sources primaires 101 (une unique source 101, dans l'exemple représenté) irradiant un réseau transmetteur 103. La source 101 peut présenter une polarisation quelconque, par exemple linéaire ou circulaire. Le réseau 103 comprend une pluralité de cellules élémentaires 105, par exemple disposées en matrice selon des lignes et des colonnes. Chaque cellule 105 comprend typiquement un premier élément d'antenne 105a, situé du côté d'une première face du réseau 103 disposée en regard de la source primaire 101, et un deuxième élément d'antenne 105b, situé du côté d'une deuxième face du réseau 103 opposée à la première face. La deuxième face du réseau 103 est par exemple tournée vers un milieu d'émission de l'antenne 100.

Chaque cellule 105 est apte, en émission, à recevoir un rayonnement électromagnétique sur son premier élément d'antenne 105a et à réémettre ce rayonnement depuis son deuxième élément d'antenne 105b, par exemple en introduisant un déphasage φ connu. En réception, chaque cellule 105 est apte à recevoir un rayonnement électromagnétique sur son deuxième élément d'antenne 105b et à réémettre ce rayonnement depuis son premier élément d'antenne 105a, en direction de la source 101, avec le même déphasage φ. Le rayonnement réémis par le premier élément d'antenne 105a est par exemple focalisé sur la source 101.

Les caractéristiques du faisceau produit par l'antenne 100, notamment sa forme (ou gabarit) et sa direction d'émission maximale (ou direction de pointage), dépendent des valeurs des déphasages respectivement introduits par les différentes cellules 105 du réseau 103.

Les antennes à réseau transmetteur ont pour avantages, entre autres, de présenter une bonne efficacité énergétique et d'être relativement simples, peu onéreuses et peu encombrantes. Cela provient notamment du fait que les réseaux transmetteurs sont réalisables en technologie planaire, généralement sur circuit imprimé.

On s'intéresse ici plus particulièrement aux antennes à réseau transmetteur 103 reconfigurable. Le réseau transmetteur 103 est dit reconfigurable lorsque les cellules élémentaires 105 sont commandables électroniquement de façon individuelle pour modifier leur valeur de déphasage φ, ce qui permet de modifier dynamiquement les caractéristiques du faisceau généré par l'antenne, et notamment de modifier sa direction de pointage sans déplacer mécaniquement l'antenne ou une partie de l'antenne au moyen d'un élément motorisé.

La figure 2 est une vue en perspective, schématique et partielle, de l'une des cellules élémentaires 105 du réseau transmetteur 103 de l'antenne 100 de la figure 1 selon un mode de réalisation.

Selon ce mode de réalisation, le premier élément d'antenne 105a de la cellule élémentaire 105 comprend une antenne à plaque 110 (« patch antenna », en anglais) adaptée à capter le rayonnement électromagnétique émis par la source 101 et le deuxième élément d'antenne 105b comprend une autre antenne à plaque 112 adaptée à émettre, vers l'extérieur de l'antenne 100, un signal déphasé. Dans l'exemple représenté, la cellule élémentaire 105 comprend en outre un plan de masse 114 intercalé entre les antennes à plaque 110 et 112.

L'antenne 110, le plan de masse 114 et l'antenne 112 sont par exemple respectivement formés dans trois niveaux de métallisation successifs, superposés et séparés les uns des autres par des couches diélectriques, par exemple en quartz. À titre d'exemple, le plan de masse 114 est séparé de chacune des antennes 110 et 112 par une épaisseur de matériau diélectrique de l'ordre de 200 µm.

Dans l'exemple représenté, un via conducteur central 116 connecte l'antenne 110 à l'antenne 112. Plus précisément, dans l'orientation de la figure 2, le via 116 présente une extrémité inférieure en contact avec une face supérieure de l'antenne 110 et une extrémité supérieure en contact avec une face inférieure de l'antenne 112. Le via conducteur central 116 est isolé électriquement du plan de masse 114. Dans l'exemple représenté, le plan de masse 114 comporte un orifice circulaire présentant un diamètre supérieur à celui du via 116, permettant ainsi au via 116 de traverser le plan de masse 114 sans que le via 116 ne soit en contact avec le plan de masse 114. À titre d'exemple, le via conducteur central 116 présente un diamètre égal à environ 80 µm.

En outre, dans cet exemple, des vias conducteurs latéraux 118, situés de part et d'autre du via conducteur central 116, connectent l'antenne 110 au plan de masse 114. Plus précisément, dans l'orientation de la figure 2, chaque via 118 présente une extrémité inférieure en contact avec la face supérieure de l'antenne 110 et une extrémité supérieure en contact avec une face inférieure du plan de masse 114. A titre de variante, dans le cas d'une commande optique, ces vias peuvent être omis dans la mesure où il n'y a alors pas de tension à contrôler.

La figure 3 est une vue de dessus, schématique et partielle, du premier élément d'antenne 105a de la cellule élémentaire 105 de la figure 2. La figure 3 illustre plus précisément l'antenne à plaque 110 de la cellule élémentaire 105.

Dans l'exemple représenté, l'antenne à plaque 110 comporte un plan conducteur 120 de forme sensiblement carrée à l'intérieur duquel est formée une fente 122, ou rainure, en forme de U. La fente 122 est par exemple sensiblement centrée par rapport au plan conducteur 120. Dans cet exemple, le via conducteur central 116 est en contact avec une zone du plan conducteur 120 située entre les deux branches du U formé par la fente 122. Le via 116 est par exemple sensiblement centré par rapport au plan conducteur 120.

En outre, dans l'exemple illustré en figure 3, les vias conducteurs latéraux 118 sont situés de part et d'autre de la fente 122. Plus précisément, chaque via 118 est par exemple connecté à une zone du plan conducteur 120 située à l'extérieur du U formé par la fente 122 et le long de l'une des branches verticales du U. Dit autrement, dans cet exemple, la zone du plan conducteur 120 où est connecté chaque via latéral 118 est séparée de la zone du plan conducteur 120 où est connecté le via central 116 par l'une des branches verticales du U formé par la fente 122. Là encore, à titre de variante, dans le cas d'une commande optique, ces vias peuvent être omis dans la mesure où il n'y a alors pas de tension à contrôler.

À titre d'exemple, le carré formé par le plan conducteur 120 présente un côté de l'ordre de 0,44 mm, les branches verticales et la branche horizontale du U formé par la fente 122 présentent chacune une longueur de l'ordre de 0,32 mm, et la fente 122 présente une largeur égale à environ 50 µm.

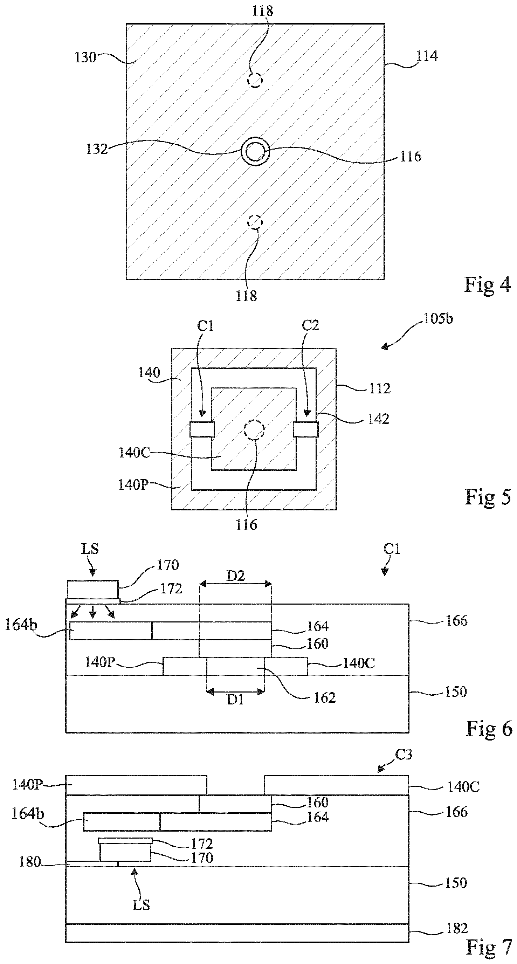

La figure 4 est une vue de dessus, schématique et partielle, d'une partie de la cellule élémentaire 105 de la figure 2. La figure 4 illustre plus précisément le plan de masse 114 situé entre les premier et deuxième éléments d'antenne 105a, 105b.

Dans l'exemple représenté, le plan de masse 114 comporte un plan conducteur 130 de forme sensiblement carrée. Dans cet exemple, le via conducteur central 116 traverse le plan de masse 114 approximativement en son centre. Le via 116 est isolé du plan conducteur 130 par une ouverture 132 annulaire, ou en forme de couronne, formée dans le plan conducteur 130 autour du via 116. À titre d'exemple, le carré formé par le plan conducteur 130 présente un côté de l'ordre de 1 mm.

Dans cet exemple, le côté du carré formé par le plan conducteur 130 définit sensiblement les dimensions externes de la cellule élémentaire 105 du réseau transmetteur 103.

Le plan de masse 114 remplit une fonction de blindage électromagnétique entre l'antenne 110 et l'antenne 112 de la cellule 105.

Dans l'exemple illustré en figure 4, les vias conducteurs latéraux 118 contactent la face inférieure du plan conducteur 130 dans des zones diamétralement opposées par rapport au via conducteur central 116. Dans cet exemple, les vias 116 et 118 sont situés sur une même droite parallèle à l'un des côtés du plan conducteur 130. En outre, les vias 118 sont équidistants du via 116. Là encore, à titre de variante, dans le cas d'une commande optique, ces vias peuvent être omis dans la mesure où il n'y a alors pas de tension à contrôler.

La figure 5 est une vue de dessus, schématique et partielle, du deuxième élément d'antenne 105b de la cellule élémentaire 105 de la figure 2. La figure 5 illustre plus précisément l'antenne à plaque 112 de la cellule élémentaire 105.

Dans l'exemple représenté, l'antenne 112 comporte un plan conducteur 140 à quatre côtés. Le plan conducteur 140 est par exemple plus précisément de forme rectangulaire ou, comme dans l'exemple illustré en figure 5, de forme sensiblement carrée.

Dans l'exemple illustré, le plan conducteur 140 comporte une ouverture 142 séparant une région centrale 140C du plan conducteur 140 d'une région périphérique 140P du plan conducteur 140. Dans cet exemple, l'ouverture 142 présente une forme sensiblement annulaire, par exemple une forme annulaire rectangulaire ou carrée.

Dans l'exemple représenté, le via conducteur central 116 est en contact avec la région centrale 140C du plan conducteur 140. Plus précisément, dans cet exemple, l'extrémité supérieure du via 116 est connectée sensiblement au centre d'une face inférieure de la région 140C. La région centrale 140C du plan conducteur 140, délimitée latéralement par l'ouverture annulaire 142, constitue par exemple une borne d'entrée de l'antenne 112.

L'antenne 112 comporte en outre un premier élément de commutation C1 et un deuxième élément de commutation C2, reliant chacun la région centrale 140C à la région périphérique 140P du plan conducteur 140. Plus précisément, dans l'exemple illustré en figure 5, les premier et deuxième éléments de commutation C1 et C2 contactent la région périphérique 140P dans des zones diamétralement opposées par rapport au via conducteur central 116. Dans cet exemple, les éléments de commutation C1 et C2 et le via conducteur 116 sont situés sur une même droite parallèle à l'un des côtés du plan conducteur 140. Dans cet exemple, le commutateur C1 est situé sensiblement à la verticale de la branche horizontale du U formé par la fente 122.

Les éléments de commutation C1 et C2 sont commandés en opposition, c'est-à-dire de sorte que, si l'un des commutateurs C1, C2 est passant, l'autre commutateur C2, C1 soit bloqué. Cela permet au deuxième élément d'antenne 105b de la cellule élémentaire 105 de commuter entre deux états de phase φ, sensiblement égaux à 0° et à 180° dans cet exemple. Les états de phase 0° et 180° correspondent respectivement au cas où le commutateur C1 est bloqué tandis que le commutateur C2 est passant, et au cas où le commutateur C1 est passant tandis que le commutateur C2 est bloqué.

À titre d'exemple, le carré formé par le plan conducteur 140 présente un côté de l'ordre de 0,44 mm, les côtés de l'ouverture annulaire carrée 142 présentent chacun une longueur de l'ordre de 0,32 mm, et l'ouverture 142 présente une largeur égale à environ 50 µm.

La figure 6 est une vue en coupe, schématique et partielle, de l'élément de commutation C1 du deuxième élément d'antenne 105b de la figure 5.

Selon un mode de réalisation, l'élément de commutation C1, ou commutateur, est à base d'un matériau à changement de phase. Les matériaux à changement de phase sont des matériaux pouvant alterner, sous l'effet de la chaleur, entre une phase cristalline et une phase amorphe, la phase amorphe présentant une résistance électrique supérieure à celle de la phase cristalline. On peut notamment tirer profit de ce phénomène pour réaliser, comme dans le cas du deuxième élément d'antenne 105b, des commutateurs présentant des états bloqué (phase amorphe) et passant (phase cristalline) différenciés par une résistance à travers le matériau à changement de phase.

Dans l'exemple illustré en figure 6, une région 160 continue en un matériau à changement de phase est située sur et en contact avec les faces supérieures des régions centrale 140C et périphérique 140P du plan conducteur 140. Dans cet exemple, les régions 140C et 140P sont disjointes et séparées l'une de l'autre par une distance D1 d'environ 1 µm. Les régions 140C et 140P sont par exemple sur et en contact avec une face d'un substrat 150 (la face supérieure du substrat 150, dans l'orientation de la figure 6). À titre d'exemple, le substrat 150 est une plaquette ou un morceau de plaquette en un matériau transparent, par exemple le verre, ou en un matériau semiconducteur, par exemple standard ou hautement résistif, par exemple le silicium.

Dans l'exemple représenté, une région électriquement isolante 162, par exemple en dioxyde de silicium, sépare latéralement la région centrale 140C de la région périphérique 140P du plan conducteur 140. La région 162 présente par exemple une épaisseur sensiblement égale à celle du plan conducteur 140, par exemple égale à environ 0,6 µm, et s'étend latéralement entre les régions 140C et 140P sur et en contact avec la face supérieure du substrat 150. Bien que cela n'ait pas été détaillé en figure 6, d'autres régions électriquement isolantes coplanaires à la région 162 peuvent en outre s'étendre latéralement entre les régions 140C et 140P ainsi qu'à l'extérieur de la région 140P. À titre d'exemple, les régions 140C et 140P peuvent en pratique être formées dans une même couche électriquement conductrice.

La région 160 en matériau à changement de phase revêt intégralement la face supérieure de la région électriquement isolante 162 et s'étend latéralement sur et en contact avec des parties des faces supérieures des régions 140C et 140P jouxtant la région 162. Les régions 140C et 140P correspondent par exemple à des première et deuxième électrodes du commutateur C1, reliées entre elles par la région 160 en matériau à changement de phase. La région 160 présente par exemple, vue de dessus, une forme sensiblement rectangulaire de largeur D2 (figure 6) égale à environ 3 µm et de longueur (dimension mesurée selon une direction orthogonale au plan de coupe de la figure 6) égale à environ 20 µm.

À titre d'exemple, la région 160 est en un matériau dit « chalcogénure », c'est-à-dire un matériau ou un alliage comprenant au moins un élément chalcogène, par exemple un matériau de la famille du tellurure de germanium (GeTe) ou du germanium-antimoine-tellure (GeSbTe, également désigné par l'acronyme « GST »).

Selon un mode de réalisation, le commutateur C1 comporte en outre un guide d'ondes 164 comportant une première extrémité en vis-à-vis d'une face de la région 160 en matériau à changement de phase et une deuxième extrémité, opposée à la première extrémité, destinée à être illuminée par une source laser LS. Plus précisément, dans l'exemple représenté, le guide d'ondes 164 revêt la face supérieure de la région 160 et s'étend latéralement jusqu'à l'aplomb de la source laser LS. Les modes de réalisation décrits ne se limitent toutefois pas à cette configuration particulière. Plus généralement, un coupleur optique peut être prévu entre le guide d'onde 164 et la région 160, la disposition relative du guide d'onde par rapport à la région 160 dépendent du design du coupleur. Le guide d'ondes 164 est un guide d'ondes dit « optique », adapté à transmettre le rayonnement émis depuis la source laser LS jusqu'au matériau à changement de phase de la région 160. À titre d'exemple, le guide d'ondes 164 comprend une région centrale, ou âme, en nitrure de silicium. Le matériau est choisi de sorte à obtenir un contraste d'indice permettant de confiner et guider le mode optique.

Dans l'exemple illustré en figure 6, la structure située du côté de la face supérieure du substrat 150, comprenant les régions 140P, 140C, 160 et 162 et le guide d'ondes 164, est revêtue d'une couche 166 électriquement isolante. Dans cet exemple, la couche 166 revêt la face supérieure et les flancs du guide d'ondes 164, ainsi qu'une partie de la face inférieure du guide d'ondes 164 qui n'est pas en contact avec la région 160. La couche 166 constitue une région périphérique entourant la région centrale du guide d'ondes 164. Le matériau de la couche 166 présente par exemple un indice optique inférieur à celui de la région centrale du guide d'ondes 164 et n'absorbe pas l'onde optique. À titre d'exemple, la couche 166 est en dioxyde de silicium.

Le guide d'ondes 164 et la couche 166 sont par exemple formés dans des couches minces d'isolation utilisées pour la réalisation de l'élément d'antenne 105b de la cellule 105. Cela permet avantageusement d'éviter la mise en oeuvre d'étapes de fabrication supplémentaires pour réaliser le guide d'ondes 164 entouré de la couche 166.

Du côté de son extrémité destinée à être illuminée par la source laser LS, le guide d'onde 164 comprend par exemple un élément de couplage d'entrée 164b aussi appelé surface ou structure d'entrée du guide d'ondes 164. Du côté de son extrémité située en vis-à-vis de la région 160 en matériau à changement de phase, le guide d'onde 164 peut en outre comprendre un élément de couplage de sortie (non détaillé sur la figure), aussi appelé surface ou structure de sortie du guide d'ondes 164. L'élément de couplage d'entrée 164b peut présenter une structure, par exemple un réseau de diffraction présentant une structure de Bragg ou toute autre structure de couplage, permettant de capter le rayonnement émis par la source laser LS et de propager ce rayonnement jusqu'à la surface de sortie. Le laser LS peut émettre une onde lumineuse verticalement à la surface du substrat. Dans ce cas, un réseau de couplage permet de diriger l'onde dans le guide, par exemple tel que décrit dans l'article « Enabling VCSEL-on-silicon nitride photonic integrated circuits with microtransfer-printing », J. Goyvaerts et al., Optica 2021, https://doi.org/10.1364/OPTICA.441636//. À titre de variante, le laser LS peut émettre une onde lumineuse longitudinale (parallèlement à la surface du substrat). Dans ce cas, un coupleur adiabatique peut amener la lumière dans le guide d'onde 164, par exemple tel que décrit dans l'articule « Heterogeneous III-V on silicon nitride amplifiers and lasers via microtransfer printing », C. Op de Beeck https://doi.org/10.1364/OPTICA.382989//.

En outre, la surface de sortie du guide d'ondes 164 peut présenter une structure permettant de réémettre le rayonnement propagé depuis la surface d'entrée vers la région 160 en matériau à changement de phase. Bien que cela n'ait pas été détaillé en figure 6, la surface de sortie du guide d'ondes 164 peut présenter une structure identique ou analogue à celle de la surface d'entrée du guide d'ondes 164.

De manière générale, les surfaces d'entrée et de sortie permettent respectivement, dans l'exemple représenté, de recevoir et de transmettre un rayonnement selon une direction orthogonale à la direction de propagation du rayonnement à l'intérieur du guide d'ondes 164. À titre de variante, au moins une surface, parmi les surfaces d'entrée et de sortie du guide d'ondes 164, peut présenter une structure permettant respectivement de recevoir ou de transmettre un rayonnement selon une direction parallèle à la direction de propagation du rayonnement à l'intérieur du guide d'ondes 164.

Dans l'exemple représenté, la source laser LS comporte une région active 170, ou région émissive, destinée à émettre un rayonnement laser. Dans cet exemple, une couche d'interface 172 située sur et en contact avec la couche 166 est intercalée entre la couche 166 et la région 170. À titre d'exemple, la région active 170 de la source laser LS est à base de fluorure de krypton (KrF). À titre de variante, la région 170 peut être en un matériau semiconducteur III-V.

La source laser LS est par exemple reportée sur la couche 166 par une technique dite de puce retournée (« flip chip », en anglais), par exemple au moyen d'un collage de type métal-métal, par exemple en mettant en oeuvre un procédé du type de celui décrit dans la publication de Y. Wang et al. intitulée « Vertical-cavity surface-emitting laser flip-chip bonding to silicon photonics chip ». À titre de variante, la source laser LS peut être réalisée par un procédé dit d'impression par transfert (« transfer printing », en anglais), par exemple tel que celui décrit dans la publication de C. Op de Beeck et al. intitulée « Heterogeneous III-V on silicon nitride amplifiers and lasers via microtransfer printing », ou par un procédé dit de collage direct (« direct bonding », en anglais), par exemple tel que celui décrit dans la publication de J. M. Ramírez et al. intitulée « Low-Threshold, High-Power On-Chip Tunable III-V/Si Lasers with Integrated Semiconductor Optical Amplifiers ».

La source laser LS peut en variante être réalisée sur un autre support indépendant de ce substrat. Dans ce cas le mode optique émis va être focalisé dans le guide d'onde par couplage sur la surface du wafer en utilisant un réseau de couplage ou sur la tranche du wafer ('butt coupling').

Pour faire basculer le commutateur C1 de l'état bloqué à l'état passant, on chauffe par exemple la région 160, à l'aide de la source laser LS, par l'intermédiaire du guide d'ondes 164, à une température T1 et pendant une durée d1. La température T1 et la durée d1 sont choisies de sorte à provoquer un changement de phase du matériau de la région 160 depuis la phase amorphe vers la phase cristalline. À titre d'exemple, la température T1 est supérieure à une température de cristallisation et inférieure à une température de fusion du matériau à changement de phase et la durée d1 est comprise entre 10 et 100 ns.

À l'inverse, pour faire basculer le commutateur C1 de l'état passant à l'état bloqué, on chauffe par exemple la région 160, à l'aide de la source laser LS, par l'intermédiaire du guide d'ondes 164, à une température T2, supérieure à la température T1, et pendant une durée d2, inférieure à la durée d1. La température T2 et la durée d2 sont choisies de sorte à provoquer un changement de phase du matériau de la région 160 depuis la phase cristalline vers la phase amorphe. À titre d'exemple, la température T2 est supérieure à la température de fusion du matériau à changement de phase et la durée d2 est de l'ordre de 10 ns.

À titre d'exemple, dans un cas où la source laser LS est à base de fluorure de krypton, un rayonnement présentant une longueur d'onde égale à environ 248 nm est émis par la source laser LS, par exemple sous forme d'impulsions, pour provoquer des transitions du matériau de la région 160 entre les phases amorphe et cristalline. Une impulsion présentant une fluence de l'ordre de 85 mJ.cm⁻² est par exemple utilisée pour obtenir une transition du matériau de la région 160 depuis la phase amorphe vers la phase cristalline. En outre, une autre impulsion présentant une fluence de l'ordre de 185 mJ.cm⁻² est par exemple utilisée pour obtenir une transition du matériau de la région 160 depuis la phase cristalline vers la phase amorphe.

Le commutateur C2 présente par exemple une structure, des dimensions et un fonctionnement analogues à ce qui a été décrit précédemment en relation avec le commutateur C1.

Le fait d'utiliser la source laser LS associée au guide d'ondes 164 pour commander les commutateurs C1 et C2 de l'élément d'antenne 105b présente l'avantage de réduire le nombre de lignes électriquement conductrices de commande. Par rapport à des commutateurs en matériau à changement de phase commandés par exemple par chauffage direct, par exemple par circulation d'un courant à travers le matériau à changement de phase, ou par chauffage indirect, par exemple par circulation d'un courant à travers un élément chauffant électriquement isolé du matériau à changement de phase, pour lesquels deux lignes de commande sont utilisées, l'une pour appliquer le potentiel de commande, l'autre pour appliquer le potentiel de référence, un seul guide d'ondes 164 est utilisé pour commander la commutation de chaque commutateur C1, C2.

Un autre avantage des commutateurs C1 et C2 tient au fait qu'ils présentent une capacité C_{off} à l'état bloqué inférieure à celle des commutateurs à chauffage indirect usuels, qui comportent typiquement un élément chauffant en un matériau électriquement conducteur, par exemple un métal, électriquement isolé du matériau à changement de phase.

Dans le réseau transmetteur 103, on peut par exemple prévoir d'utiliser une source laser LS différente pour commander chaque commutateur C1, C2 de chaque deuxième élément d'antenne 105b, l'émission des sources laser LS du réseau transmetteur 103 étant commandée par un circuit de commande (non représenté). À titre de variante, on peut prévoir d'utiliser une même source laser LS pour commander plusieurs commutateurs C1, C2 des deuxièmes éléments d'antenne 105b du réseau transmetteur 103. Dans ce cas, chaque deuxième élément d'antenne 105b peut par exemple être associé à un commutateur optique de commande des commutateurs C1 et C2 en opposition de phase ou à un multiplexeur de type « 1 vers N », avec N entier strictement supérieur à deux, adapté à commander plusieurs commutateurs C1, C2 de plusieurs deuxièmes éléments d'antenne 105b.

Un avantage des commutateurs C1 et C2 à base de matériau à changement de phase tient au fait qu'ils sont capables de fonctionner à des niveaux de puissance au moins aussi élevés que les commutateurs généralement employés dans des cellules élémentaires d'antennes à réseau transmetteur ou réflecteur reconfigurable, tout en présentant une meilleure linéarité. En outre, les commutateurs C1 et C2 présentent une excellente stabilité dans des plages de fréquences de l'ordre du térahertz.

En outre, le réseau transmetteur 103 comprenant des cellules 105 intégrant les commutateurs C1 et C2 présente avantageusement une consommation énergétique moindre que les réseaux transmetteurs actuels comportant par exemple des composants tels que des diodes p-i-n ou des varactors.

La figure 7 est une vue en coupe, schématique et partielle, d'un autre commutateur C3 à base d'un matériau à changement de phase selon un mode de réalisation.

Le commutateur C3 de la figure 7 comprend des éléments communs avec le commutateur C1 de la figure 6. Ces éléments communs ne seront pas détaillés à nouveau ci-après. Le commutateur C3 de la figure 7 diffère du commutateur C1 de la figure 6 en ce que, dans le commutateur C3 de la figure 7, la structure comportant la source laser LS, la couche 166, le guide d'ondes 164 et les régions 140P, 140C, 160 et 162 est, en comparaison du commutateur C1 de la figure 6, tournée par rapport à la face supérieure du substrat 150. L'exemple illustré en figure 7 correspond par exemple à un cas où le commutateur C3 à base de matériau à changement de phase est réalisé sur un substrat dit « fonctionnalisé ».

Plus précisément, dans l'exemple illustré en figure 7, les régions 140P et 140C sont sur et en contact avec la face supérieure de la couche 166 électriquement isolante, c'est-à-dire la face de la couche 166 opposée au substrat 150. La région 160 en matériau à changement de phase est sous et en contact avec les régions 140P et 140C sus-jacentes. En outre, le guide d'ondes 164 est en contact, par une partie de sa face supérieure, avec la région 160. Dans l'exemple représenté, la région active 170 de la source laser LS est sur et en contact avec une région électriquement conductrice 180 sous-jacente, située sur et en contact avec la face supérieure du substrat 150. La région 180 permet par exemple de polariser la région active 170 de la source laser LS pour commander son émission. Dans cet exemple, une couche électriquement conductrice 182 revêt la face inférieure du substrat 150.

Bien que cela n'ait pas été détaillé en figure 7, des vias électriquement conducteurs permettant de connecter respectivement la couche d'interface 172 et la région 180 à des pistes conductrices situées du côté des électrodes 140P et 140C, par exemple formées dans le plan conducteur 140, peuvent être prévus dans la structure du commutateur C3.

Le commutateur C3 de la figure 7 présente un fonctionnement analogue à celui du commutateur C1 de la figure 6, et procure des avantages similaires. À titre d'exemple, chaque commutateur C1, C2 du deuxième élément d'antenne 105b peut être substitué par un commutateur présentant une structure identique ou similaire à celle du commutateur C3. En outre, bien que cela n'ait pas été détaillé, on peut prévoir que chaque cellule 105 du réseau transmetteur 103 comporte un ou plusieurs autres commutateurs identiques ou analogues chacun au commutateur C1, C2 ou C3.

Dans les exemples décrits ci-dessus en relation avec les figures 6 et 7, la source laser LS est de type « intégrée », c'est-à-dire qu'elle fait partie d'une même puce que le ou les commutateurs auxquels elle est associée. À titre de variante, on pourrait prévoir une source laser LS non intégrée, c'est-à-dire formée sur une puce différente de celle du ou des commutateurs auxquels elle est associée, la source laser LS étant alors par exemple connectée au guide d'ondes de chaque commutateur auquel elle est associée par une liaison optique, par exemple une fibre optique.

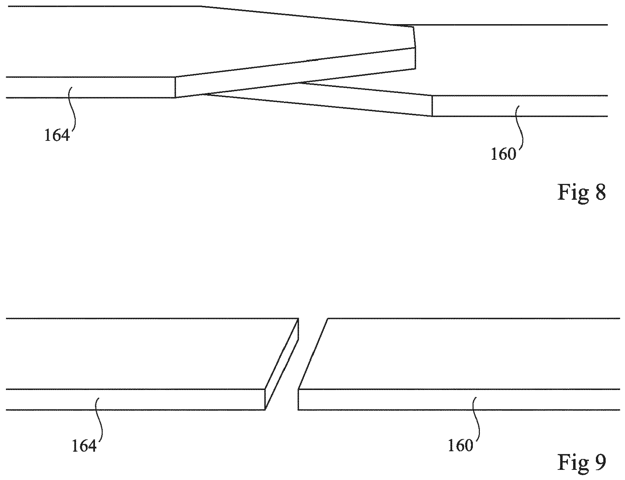

La figure 8 est une vue en perspective de la surface de sortie du guide d'ondes 164 selon un mode de réalisation.

Dans l'exemple représenté, le guide d'ondes 164 est superposé à la région 160 en matériau à changement de phase. Plus précisément, dans cet exemple, une face du guide d'ondes 164 (la face inférieure du guide d'ondes 164, dans l'orientation de la figure 8) est sur et en contact avec une face de la région 160 en matériau à changement de phase (la face supérieure de la région 160, dans l'orientation de la figure 8). La surface de sortie du guide d'ondes 164 présente par exemple une forme fuselée (« tapered », en anglais) se rétrécissant au voisinage de la région 160 en matériau à changement de phase. De façon analogue, la région 160 en matériau à changement de phase peut, comme dans l'exemple illustré, présenter une forme fuselée se rétrécissant au voisinage du guide d'ondes 164. Dans cet exemple, le guide d'ondes 164 et la région 160 en matériau à changement de phase présentent un couplage dit « adiabatique ».

La figure 9 est une vue en perspective d'une surface de sortie d'un guide d'ondes selon un autre mode de réalisation.

Dans l'exemple représenté, le guide d'ondes 164 et la région 160 en matériau à changement de phase sont sensiblement coplanaires. Dans l'exemple illustré, la surface de sortie du guide d'ondes 164 comprend par exemple une face du guide d'ondes 164 située en vis-à-vis d'une face de la région 160 en matériau à changement de phase, lesdites faces étant sensiblement parallèles entre elles et orthogonales à une direction de propagation de la lumière dans le guide d'ondes 164. Dans cet exemple, le guide d'ondes 164 et la région 160 en matériau à changement de phase présentent un couplage dit « bout à bout » (« butt coupling », en anglais).

Bien que les figures 8 et 9 illustrent des modes de réalisation de la surface de sortie du guide d'ondes 164, une structure identique ou analogue à celle de la figure 8 ou de la figure 9 pourrait être prévue au niveau de la surface d'entrée du guide d'ondes 164 pour réaliser le couplage optique entre la source laser LS et le guide d'ondes 164.

Bien que l'on ait décrit ci-dessus en relation avec les figures 1 à 9 des exemples d'application à des antennes à réseau transmetteur, les modes de réalisation décrits sont transposables par la personne du métier à des applications utilisant des antennes à réseau réflecteur. De telles antennes comprennent typiquement une ou plusieurs sources primaires irradiant un réseau réflecteur comportant une pluralité de cellules élémentaires, par exemple disposées en matrice selon des lignes et des colonnes, chaque cellule comprenant typiquement un élément d'antenne, situé du côté d'une première face du réseau disposée en regard de la source primaire et tournée vers un milieu d'émission de l'antenne, et un élément réflecteur, situé du côté d'une deuxième face du réseau opposée à la première face.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la forme de l'élément d'antenne 105a peut être adaptée en fonction de la polarisation de la source 101 associée.

En outre, bien que l'on ait décrit un exemple de cellule élémentaire 105 comportant deux commutateurs en matériau à changement de phase C1 et C2, les modes de réalisation décrits sont transposables par la personne du métier à un nombre quelconque de commutateurs en matériau à changement de phase. À titre d'exemple, on pourrait prévoir un nombre de commutateurs en matériau à changement de phase supérieur à deux dans un cas où l'on souhaiterait réaliser une cellule élémentaire reconfigurable présentant plus de deux états de phase différents.

Par ailleurs, bien que l'on ait décrit ci-dessus uniquement un exemple d'application à des antennes à réseau transmetteur ou réflecteur, les commutateurs à base de matériau à changement de phase à commande optique, décrits en relation avec les figures 6 et 7, peuvent avoir d'autres applications. Plus généralement, de tels commutateurs peuvent être utilisés dans toute application susceptible de tirer profit d'une diminution du nombre de pistes de connexion électrique pour commander un commutateur. A titre d'exemple, de tels commutateurs peuvent être intégrés à des filtres, des circuits déphaseurs, etc. et, plus généralement, à tout type d'application utilisant un commutateur.

Enfin, la mise en oeuvre pratique des modes de réalisation et variantes décrits est à la portée de la personne du métier à partir des indications fonctionnelles données ci-dessus.

## Revendications

1. Commutateur (C1, C2 ; C3) à base d'un matériau à changement de phase comprenant :
- une région (160) en ledit matériau à changement de phase reliant des première et deuxième électrodes de conduction (140P, 140C) du commutateur ; et
- un guide d'ondes (164) comportant une première extrémité en vis-à-vis d'une face de la région (160) en ledit matériau à changement de phase et une deuxième extrémité, opposée à la première extrémité, destinée à être illuminée par une source laser (LS),
dans lequel le guide d'ondes comprend en outre, du côté de ses deuxième et première extrémités, des surfaces d'entrée et de sortie permettant respectivement de recevoir et de transmettre un rayonnement selon une direction orthogonale à la direction de propagation du rayonnement à l'intérieur du guide d'ondes.

2. Commutateur (C1, C2 ; C3) selon la revendication 1, dans lequel le guide d'ondes (164) comprend une région centrale en nitrure de silicium entourée d'une région périphérique (166) en dioxyde de silicium.

3. Commutateur (C1, C2 ; C3) selon la revendication 1 ou 2, dans lequel ledit matériau à changement de phase est un matériau chalcogénure.

4. Commutateur (C1, C2 ; C3) selon l'une quelconque des revendications 1 à 3, dans lequel les première et deuxième électrodes de conduction (140P, 140C) font partie d'un élément d'antenne (105b) d'une cellule (105) de réseau transmetteur (103) ou de réseau réflecteur.

5. Commutateur (C1, C2) selon l'une quelconque des revendications 1 à 4, dans lequel les première et deuxième électrodes de conduction (140P, 140C) sont sur et en contact avec une face d'un substrat (150).

6. Commutateur (C3) selon l'une quelconque des revendications 1 à 4, dans lequel les première et deuxième électrodes de conduction (140P, 140C) sont sur et en contact avec une face d'une couche électriquement isolante (166) revêtant un substrat (150).

7. Commutateur selon l'une quelconque des revendications 1 à 6, dans lequel au moins une extrémité, parmi les première et deuxième extrémités du guide d'ondes (164), présente une forme fuselée.

8. Cellule (105) de réseau transmetteur (103) ou de réseau réflecteur comprenant au moins un commutateur (C1, C2 ; C3) selon l'une quelconque des revendications 1 à 7.

9. Réseau transmetteur (103) ou réseau réflecteur comprenant :
- une pluralité de cellules (105) selon la revendication 8 ;
- une ou plusieurs sources laser (LS) ; et
- un circuit de commande de la ou des sources laser (LS) .

10. Réseau selon la revendication 9, dans lequel chaque source laser (LS) fait partie d'une même puce que chaque commutateur (C1, C2 ; C3) auquel elle est associée.

11. Réseau selon la revendication 9, dans lequel chaque source laser (LS) fait partie d'une puce différente de celle dont fait partie chaque commutateur (C1, C2 ; C3) auquel elle est associée, la source laser étant connectée au guide d'ondes (164) dudit commutateur par une fibre optique.

12. Antenne (100) comprenant un réseau transmetteur (103) ou un réseau réflecteur selon l'une quelconque des revendications 9 à 11 et au moins une source (101) configurée pour irradier une face du réseau.
